# EUROPÄISCHE PATENTSCHRIFT

(11) **EP 0 964 611 B1**
(45) Veröffentlichungstag und Bekanntmachung des Hinweises auf die Patenterteilung: **14.03.2001**
(21) Anmeldenummer: 99111133.7
(22) Anmeldetag: 08.06.1999
(51) Int. Cl.: H05K 9/00, H02G 3/22, H02G 3/08, H02G 15/007

(54) **Kabeldurchführungsvorrichtung**
Cable feedthrough device
Dispositif pour traversée de câble

(30) Priorität: 09.06.1998 DE 19825672
(43) Veröffentlichungstag der Anmeldung: 15.12.1999
(73) Patentinhaber: Vogt, Martin Peter, 59757 Arnsberg (DE)
(72) Erfinder: Vogt, Martin, 59759 Arnsberg (DE)
(74) Vertreter: Basfeld, Rainer, Dr. Dipl.-Phys.

(56) Entgegenhaltungen:
- EP-A- 0 780 924
- DE-A- 4 038 690
- DE-U- 29 619 379
- US-A- 5 003 130

## Beschreibung

Die vorliegende Erfindung betrifft eine Kabeldurchführungsvorrichtung, insbesondere eine Kabeldurchführungsvorrichtung mit einem Stopfen aus einem elastischen Material, der eine durchgehende Bohrung für die Aufnahme eines Kabels und eine Nut für die Einbringung des Stopfens in eine Bohrung in einer Wandung umfaßt, wobei die Kabeldurchführungsvorrichtung eine EMV-gerechte Abschirmeinheit umfaßt.

Eine Kabeldurchführungsvorrichtung der vorgenannten Art ist aus der EP 0 780 924 A2 bekannt. Hier wird eine zweiteilige Kabeldurchführungsvorrichtung beschrieben, wobei das innenliegende als Stopfen aus einem elastischen Material anzusehende Rastelement aus einer relativ aufwendigen meanderförmigen Struktur besteht, welche durch einen aufschiebbaren Ring zusammengepreßt und arretiert werden kann.

Eine weitere Kabeldurchführungsvorrichtung ist ebenfalls aus der DE-A-4441478 bekannt. Eine derartige Kabeldurchführungsvorrichtung wird beispielsweise dafür verwendet, ein Kabel aus einem Schaltschrank herauszuführen. Insbesondere beschreibt die in der vorgenannten Offenlegungsschrift genannte Kabeldurchführungsvorrichtung lediglich eine Halterung für Kabel, welche vermittels eines Kabelbinders eine zugentlastende Funktion übernehmen kann. Als nachteilig erweist sich hierbei zum einen, dass eine relativ aufwendige Kabeldurchführungsleiste vorgesehen werden muß. Weiterhin können durch die aus dem Stand der Technik bekannte Kabeldurchführungsvorrichtung keine beispielsweise durch Schaltvorgänge innerhalb des Schaltschrankes hervorgerufenen elektromagnetischen Wellen daran gehindert werden, durch die für die Kabeldurchführungsvorrichtung vorgesehene Öffnung zumindest teilweise aus dem Schaltschrank herauszutreten.

Eine HF-dichte Kabeldurchführungsvorrichtung wird in der DE 40 38 690 A1 offenbart. Hier wird die Kombination einer Trägerplatte sowie durch Einhängen oder Einrasten einer lösbar befestigten Druckplatte beschrieben, wobei das Kabel zwischen den beiden obengenannten Platten durch eine muldenförmige Ausnehmung eingeklemmt werden kann. Die gesamte Anordnung ist vor einer stützförmigen Öffnung eines Gehäuses einhängbar und bildet somit eine Kabeldurchführung mit gleichzeitiger HF-Abschirmung.

Eine weitere Kabeldurchführungsvorrichtung ist aus der deutschen Offenlegungsschrift DE 40 04 550 A1 bekannt. Eine derartige Kabeldurchführungsvorrichtung wird ebenfalls dafür verwendet, ein Kabel aus einem Schaltschrank herauszuführen. Hierbei kann beispielsweise in dem Schaltschrank eine Bohrung vorgesehen sein, wobei die die Bohrung umgebenden Teile der Schaltschrankwandung in die Nut des Stopfens eingreifen können. Als nachteilig bei einer derartigen Kabeldurchführungsvorrichtung erweist sich, dass bei starkem, plötzlichem Zug an dem Kabel der gesamte Stopfen zusammen mit dem Kabel aus der Wandung des beispielsweise Schaltschranks herausgerissen werden kann.

Das der vorliegenden Erfindung zugrunde liegende Problem ist die Schaffung einer Kabeldurchführungsvorrichtung der eingangs genannten Art, die hinsichtlich des Durchtritts von elektromagnetischer Strahlung sicherer gestaltet ist beziehungsweise insbesondere nachträglich sicherer gestaltbar ist.

Dies wird erfindungsgemäß durch die kennzeichnenden Merkmale des Anspruchs 1 erreicht. Durch die Abschirmeinheit wird erreicht, daß durch Schaltvorgänge in dem beispielsweise Schaltschrank hervorgerufene Störsignale nicht durch die Kabeldurchführung hindurch aus dem Schaltschrank austreten können. Die erfindungsgemäße Ausführungsform, bei der die Abschirmeinheit aus zwei Teilen besteht, eignet sich für das nachträgliche Anbringen der durch die Abschirmeinheit gegebenen EMV-gerechten Abschirmung an beispielsweise bereits eingebauten Kabeldurchführungsvorrichtungen.

Gemäß einer bevorzugten Ausführungsform der vorliegenden Erfindung können die beiden Teile der Abschirmeinheit miteinander verclipst werden. Dadurch ergibt sich eine besonders einfache insbesondere auch nachträgliche Anbringbarkeit der Abschirmeinheit an einer Kabeldurchführungsvorrichtung.

Gemäß einer bevorzugten Ausführungsform der vorliegenden Erfindung weist die Zugentlastungseinheit eine Halteklammer auf, mit der die Zugentlastungseinheit an dem Kabel festgeklemmt werden kann. Weiterhin kann die Zugentlastungseinheit einen etwa halbkreisförmigen Bügel aufweisen, der in die Nut des Stopfens eingreifen kann. Hierbei kann ein von der Zugentlastungseinheit umfaßter stegförmiger Schenkel sich zwischen der Halteklammer und dem Bügel erstrecken. Die Zugentlastungseinheit ist somit einfach dadurch montierbar, daß der Bügel in die Nut des in der Wandung befindlichen Stopfens eingeführt und die Halteklammer am Kabel festgeklemmt wird. Auf diese Weise wird eine einfach gestaltete, schnell montierbare Zugentlastung realisiert, durch die die aus dem Stand der Technik bekannten Nachteile vermieden werden.

Der Stopfen kann aus allen üblicherweise verwendeten Materialien wie Weichkautschuk oder Kunststoff, beispielsweise aus EPDM, Silikon oder Neopren bestehen. Die Zugentlastungseinheit kann beispielsweise aus Federstahl, leitendem Kunststoff oder mit leitfähiger Masse beschichtetem Kunststoff gefertigt sein.

Die Abschirmeinheit kann vorteilhafterweise aus einem Drahtgeflecht oder einer metallischen Folie oder aus einer metallisch beschichteten Folie oder aus mindestens einem metallisch beschichteten Teil aus Kunststoff bestehen. Sie kann den Stopfen im Bereich zwischen Bügel und Halteklammer zumindest teilweise umgeben sowie ebenfalls Teile des stegförmigen Schenkels der Zugentlastungseinheit. Hierzu kann die Abschirmeinheit beispielsweise auf der von dem Kabel abgewandten Seite des stegförmigen Schenkels befestigbar sein oder befestigt sein. Vorzugsweise kann sie aufklebbar oder aufnietbar sein oder aufgeklebt oder aufgenietet sein. Bei einer derartigen Befestigung kann die Abschirmeinheit beispielsweise bei Gebrauch auseinander gefaltet und um entsprechende Teile des Stopfens mit daran befestigter Zugentlastungseinheit herumgelegt werden.

Alternativ dazu kann die Abschirmeinheit auch als über Teile des Stopfens mit daran befestigter Zugentlastungseinheit aufschiebbare Hülse ausgeführt sein. Alle drei aufgeführten Möglichkeiten bieten den Vorteil einer schnellen Montage.

Es besteht weiterhin die Möglichkeit, daß Zugentlastungseinheit und Abschirmeinheit zusammen als Clip ausgeführt sind, der beispielsweise durch Einbringen des Bügels in die Nut und Festklammern der Halteklammer an dem Kabel an der Kabeldurchführungsvorrichtung schnell und einfach befestigbar sind.

Vorzugsweise ist die Form der Abschirmeinheit an die Form des Stopfens angepaßt und weist beispielsweise eine im wesentlichen kegelstumpfförmige Gestalt auf.

Vorteilhafterweise kann die Abschirmeinheit Nasen aufweisen, die in die mit der Erde verbundene Abschirmung des Kabels eingreifen können. Auf diese Weise kann die Abschirmung die in dem beispielsweise Schaltschrank entstehenden elektrischen Störsignale wirksam abschirmen.

Vorzugsweise weisen der von der Zugentlastungseinheit umfaßte halbkreisförmige Bügel und/oder die Abschirmeinheit eine Oberflächenstrukturierung auf, die der Wandung, durch die das Kabel hindurchgeführt werden soll, zugewandt ist. Die Wandung eines abzuschirmenden Schaltschranks kann beispielsweise nach einer Pulverbeschichtung auch im Bereich um die Bohrung für den Stopfen mit nichtleitendem Material beschichtet sein. Gemäß dem Stand der Technik wird zur Vermeidung einer derartigen Beschichtung vor dem Pulverbeschichten eine mit leitendem Kleber und mit Schutzfolie abgedeckte Scheibe um die Bohrung herum angebracht. Durch die aufgerauhte, beispielsweise durch Prägung oder entsprechende Beschichtung erzeugte Oberflächenstrukturierung des halbkreisförmigen Bügels und/oder der Abschirmung kann auf derartig aufwendige Maßnahmen verzichtet werden. Durch kurzes Drehen der Oberflächenstrukturierung an den die Bohrung umgebenden, eventuell beschichteten Wandungsabschnitten werden diese ebenfalls aufgerauht, so daß eine leitende Verbindung zwischen der Zugentlastungseinheit und/oder der Abschirmeinheit und der Wandung des Schaltschranks entsteht.

Weitere Vorteile und Merkmale der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: einen Längsschnitt durch ein erfindungsgemäßes Gummiteil;
- Fig. 2: eine Vorderansicht einer erfindungsgemäßen Zugentlastungseinheit;
- Fig. 3: eine Seitenansicht einer erfindungsgemäßen Zugentlastungseinheit;
- Fig. 4: einen Längsschnitt durch eine erfindungsgemäße Kabeldurchführungsvorrichtung ohne daran angebrachte Abschirmeinheit;
- Fig. 5: eine Seitenansicht einer Kabeldurchführungsvorrichtung;
- Fig. 6: einen Längsschnitt durch eine Ausführungsform einer erfindungsgemäßen Abschirmeinheit;
- Fig. 7: eine Ansicht gemäß dem Pfeil VII in Fig. 6.

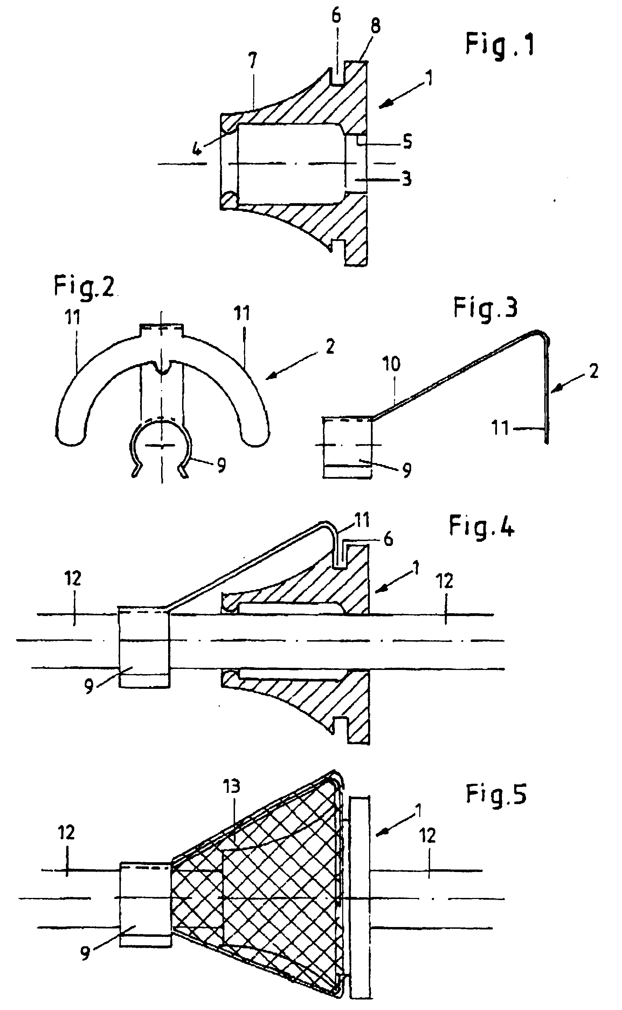

Wie aus Fig. 1 bis 4 ersichtlich ist, umfaßt eine erfindungsgemäße Kabeldurchführungsvorrichtung einen beispielsweise als Gummiteil ausgeführten Stopfen 1 und eine Zugentlastungseinheit 2. Der Stopfen 1 weist eine durchgehende Bohrung 3 auf, durch die ein Kabel 12 hindurchführbar ist. Jeweils im Austritts- und im Eintrittsbereich des Kabels 12 in die durchgehende Bohrung 3 weist der Stopfen 1 Dichtwulste 4, 5 auf, die vergleichsweise dicht an dem Kabel 12 anliegen.

Der Stopfen 1 ist rotationssymetrisch ausgebildet und weist weiterhin eine umlaufende Nut 6 auf, in die die Wandung, durch die das Kabel 12 hindurchgeführt werden soll, eingreifen kann. An die Nut 6 schließt sich bei dem in Fig. 1 abgebildeten Ausführungsbeispiel ein konischer Abschnitt 7 an, längs dem der Außendurchmesser des Stopfens 1 mit zunehmenden Abstand von der Nut 6 abnimmt. Auf der gegenüberliegenden Seite der Nut 6 umfaßt der Stopfen 1 einen äußeren im wesentlichen zylindrischen Abschnitt 8.

Der Stopfen 1 kann beispielsweise dadurch in eine Bohrung der Wandung, durch die das Kabel 12 hindurchgeführt werden soll, eingebracht werden, daß er zuerst mit dem konischen Abschnitt 7 in die Bohrung eingeführt wird, bis sich die die Bohrung umgebende Wandung in der Nut 6 befindet. Daran anschließend kann das Kabel 12 durch den Stopfen 1 hindurchgeführt werden.

Der Stopfen 1 kann beispielsweise aus Weichkautschuk oder Kunststoff, insbesondere aus Silikon, Neopren oder EPDM bestehen. Weiterhin können jeweils der Innendurchmesser der durchgehenden Bohrung 3 und die Innendurchmesser der Dichtwulste 4, 5 an den Außendurchmesser der durchzuführenden Kabel angepaßt werden.

Das in Fig. 2 und Fig. 3 detaillierte abgebildete Ausführungsbeispiel einer Zugentlastungseinheit 2 umfaßt eine Halteklammer 9 mit zwei Klemmschenkeln, deren Querschnitt etwa halbkreisförmig ist. Diese Klemmschenkel der Halteklammer 9 können das Kabel 12 umgreifen und von dem Benutzer beispielsweise mit einer Zange fest an das Kabel angepreßt werden. Die Zugentlastungseinheit 2 umfaßt weiterhin einen von der Halteklammer 9 ausgehenden stegförmigen Schenkel 10, der sich ausgehend von der Halteklammer 9 relativ von dieser und dem darin befindlichen Kabel 12 schräg nach außen erstreckt. An seinem von der Halteklammer abgewendeten Ende geht der stegförmige Schenkel 10 in einen halbkreisförmigen Bügel 11 über, dessen Innendurchmesser etwa dem Durchmesser der Nut 6 entspricht.

Wie aus Fig. 4 ersichtlich ist, kann dementsprechend der halbkreisförmige Bügel 11 der Zugentlastungseinheit 2 in die Nut 6 eingreifen, wobei gleichzeitig das Kabel von der Halteklammer 9 fest umgriffen wird, so daß sich dadurch eine Zugentlastung des durch den Stopfen 1 hindurchgeführten Kabels 12 ergibt. Der Bügel 11 kann auf einer der Wandung zugewandten Oberfläche aufgerauht sein.

In Fig. 5 ist ein Beispiel einer Kabeldurchführungsvorrichtung abgebildet, bei der gleichzeitig eine EMV-gerechte Abdeckung der Zugentlastungseinheit 2 vorgesehen ist. In dem abgebildeten Beispiel umgreift aine als Kegelstumpfförmiges Drahtgeflecht ausgebildete Abschirmeinheit 13 den stegförmigen Schenkel 10 der Zugentlastungseinheit 2 sowie den konischen Abschnitt 7 des Stopfens 1. Anstelle eines Drahtgeflechts kann auch eine metallische Folie oder eine metallisch beschichtete Folie verwendet werden. Anstelle eines Kegelstumpfs oder eines Kegelstumpfabschnitts können auch geometrische Abwandlungen vorgesehen sein, um die Abschirmeinheit 13 an eventuell anders geformte Stopfen 1 anzupassen.

Es besteht die Möglichkeit, eine als metallische Folie oder Drahtgeflecht ausgeführte Abschirmeinheit 13 teilweise auf die Außenseite des stegförmigen Schenkels 10 aufzukleben oder aufzunieten. Es ist denkbar, eine derartige Abschirmeinheit 13 zusammengelegt zu vertreiben und bei der Montage einer erfindungsgemäßen Kabeldurchführungsvorrichtung auseinander zu falten, auf die Außenseite des stegförmigen Schenkels 10 aufzukleben und um den Stopfen 1 herum zu legen. Alternativ können auch vorgeformte, beispielsweise konische Hütchen als Abschirmeinheit 13 dienen, die auf die bereits montierte Kabeldurchführungsvorrichtung aufgeschoben werden, so daß sie an der Außenseite des stegförmigen Schenkels 10 und an dem beispielsweise konischen Abschnitt 7 des Stopfens 1 anliegen.

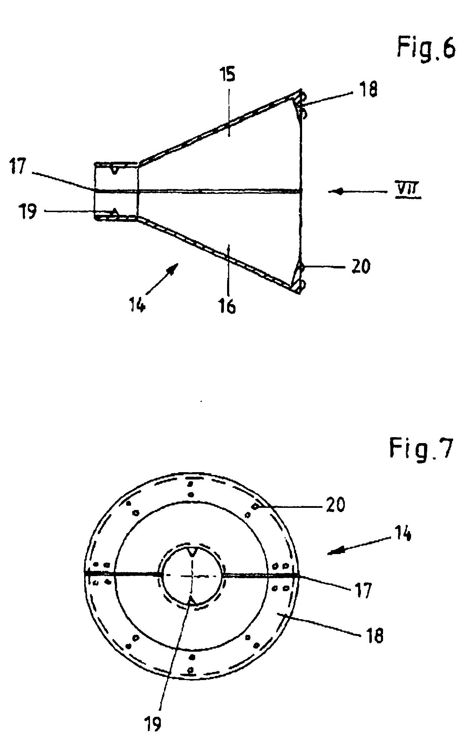

Wie aus Fig. 6 und Fig. 7 ersichtlich ist, besteht auch die Möglichkeit, zwei als Kegelstumpfhälften ausgeführte Teile 15, 16 beispielsweise aus Drahtgeflecht, Metallfolie oder leitend beschichteten Kunststoff-Formteilen als Abschirmung 14 vorzusehen, die in Form eines Clips von zwei Seiten um den stegförmigen Schenkel und den konischen Abschnitt herumgelegt und aneinandergeclipst werden können.

In Fig. 6 und Fig. 7 ist die Verbindungslinie zwischen den beiden miteinander verclipsbaren Teilen 15, 16 mit dem Bezugszeichen 17 versehen. Die Teile 15, 16 weisen an der Basis des Kegelstumpfes einen radial nach innen gerichteten Abschnitt 18 auf, mit dem die die Abschirmeinheit 14 bildenden Teile 15, 16 in die Nut 6 des Stopfens 1 eingreifen können.

Erfindungsgemäß kann ebenfalls vorgesehen sein, an einer derartigen Abschirmeinheit 14 Nasen 19 anzubringen, um eine leitende Verbindung zwischen der Abschirmung des Kabels 12 und der Abschirmeinheit 14 zu erzielen. Fig. 6 und Fig. 7 ist eine an der Unterseite des Kegelstumpfes angeordnete, beispielsweise punktförmig hervorstehende Oberflächenstrukturierung 20 der Teile 15, 16 entnehmbar. Durch Einschieben des Abschnitts 18 in die Nut 6 des Stopfens 1 wird punktuell die Lackierung der Wandung, durch die das Kabel hindurchgeführt werden soll, entfernt, so daß zwischen der Wandung und der Abschirmeinheit 14 eine leitende Verbindung entsteht.

Weiterhin besteht die Möglichkeit, die Abschirmeinheit 13, 14 mit einer selbstklebenden einseitigen Beschichtung zu versehen, um bei der Montage durch entsprechende Materialüberlappung und Verklebung eine Halterung der Abschirmeinheit 13, 14 zu gewährleisten.

Weiterhin besteht die Möglichkeit, eine Zugentlastungseinheit 2 zusammen mit einer Abschirmeinheit 13, 14 als Clip auszuführen, der nur noch mit entsprechenden halbkreisförmigen Bügeln 11 in die Nut 6 des Stopfens 1 eingeführt werden muß und mit der Halteklammer 9 an dem Kabel 12 festgeklemmt werden muß.

Es besteht weiterhin die Möglichkeit vor Beschichtung von Gehäuseteilen, insbesondere der Wandung, durch die das Kabel 12 hindurchgeführt werden soll, eine leitfähige beidseitig selbstklebende, mit abziehbarer Schutzfolie beschichtete Kreisringfolie aufzukleben, die im Bereich der Gehäuselochung innenseitig angeordnet ist. Vor der Montage des Stopfens 1 wird die Schutzfolie der Kreisringfolie entfernt. Daran anschließend wird die beispielsweise als Kegelstumpf ausgeführte Abschirmeinheit 13, 14 montiert und durch den Kontakt der Unterseite des Kegelstumpfes mit der leitfähigen aufgeklebten Kreisringfolie die elektrisch leitende Verbindung zwischen der als Hohlkegelstumpf ausgeführten Abschirmeinheit 13, 14 und der Wandung, durch die das Kabel 12 hindurchgeführt wird, hergestellt. Insbesondere ist bei einer derartig montierten Abschirmeinheit 13, 14 die Unterseite des Kegelstumpfes vollflächig mit der Wandung des Gehäuses elektrisch leitend verbunden, so daß eine ausgezeichnete EMV-gerechte Abschirmung erzielt wird.

## Patentansprüche

1. Kabeldurchführungsvorrichtung mit einem Stopfen (1) aus einem elastischen Material, der eine durchgehende Bohrung (3) für die Aufnahme eines Kabels (12) und eine Nut (6) für die Einbringung des Stopfens (1) in eine Bohrung in einer Wandung umfaßt, wobei die Kabeldurchführungsvorrichtung, eine EMV-gerechte Abschirmeinheit (13, 14) umfaßt, dadurch gekennzeichnet, dass die Kabeldurchführungsvorrichtung weiterhin eine Zugentlastungseinheit (2) umfaßt und dass die Abschirmeinheit (13, 14) aus zwei Teilen (15, 16) besteht, die um Teile des Stopfens (1) mit daran befestigter Zugentlastungseinheit (2) herum angeordnet und aneinander befestigt werden können.

2. Kabeldurchführungsvorrichtung nach Anspruch 1, dadurch gekennzeichnet, dass die Zugentlastungseinheit (2) eine Halteklammer (9) aufweist, mit der die Zugentlastungseinheit (2) an dem Kabel (12) festgeklemmt werden kann.

3. Kabeldurchführungsvorrichtung nach einem der Ansprüche 1 oder 2, dadurch gekennzeichnet, dass die Zugentlastungseinheit (2) einen etwa halbkreisförmigen Bügel (11) aufweist, der in die Nut (6) des Stopfens (1) eingreifen kann.

4. Kabeldurchführungsvorrichtung nach einem der Ansprüche 2 oder 3, dadurch gekennzeichnet, dass die Zugentlastungseinheit (2) weiterhin einen stegförmigen Schenkel (10) umfaßt, der sich zwischen der Halteklammer (9) und dem Bügel (11) erstreckt.

5. Kabeldurchführungsvorrichtung nach einem der Ansprüche 1 bis 4, dadurch gekennzeichnet, dass die Abschirmeinheit (13, 14) aus einem Drahtgeflecht oder einer metallischen Folie oder aus einer metallisch beschichteten Folie oder aus mindestens einem metallisch beschichteten Teil (15, 16) aus Kunststoff besteht.

6. Kabeldurchführungsvorrichtung nach einem der Ansprüche 4 oder 5, dadurch gekennzeichnet, dass die Abschirmeinheit (13, 14) auf der von dem Kabel (12) abgewandten Seite des stegförmigen Schenkels (10) befestigbar ist oder befestigt ist, vorzugsweise aufklebbar oder aufnietbar ist oder aufgeklebt oder aufgenietet ist.

7. Kabeldurchführungsvorrichtung nach einem der Ansprüche 1 bis 6, dadurch gekennzeichnet, dass die Abschirmeinheit (13, 14) eine im wesentlichen kegelstumpfförmige Gestalt aufweist.

8. Kabeldurchführungsvorrichtung nach einem der Ansprüche 1 bis 7, dadurch gekennzeichnet, dass die Abschirmeinheit (13, 14) Nasen (19) aufweist, die in die mit der Erde verbundene Abschirmung des Kabels (12) eingreifen können.

9. Kabeldurchführungsvorrichtung nach einem der Ansprüche 1 bis 8, dadurch gekennzeichnet, dass der Stopfen (1) aus Weichkautschuk oder Kunststoff, insbesondere aus EPDM, Silikon oder Neopren besteht.

10. Kabeldurchführungsvorrichtung nach einem der Ansprüche 1 bis 9, dadurch gekennzeichnet, dass der von der Zugentlastungseinheit (2) umfaßte halbkreisförmige Bügel (11) und/oder die Abschirmeinheit (14) eine Oberflächenstrukturierung (20) aufweist, die der Wandung, durch die das Kabel (12) hindurchgeführt werden soll, zugewandt ist.

11. Kabeldurchführungsvorrichtung nach einem der Ansprüche 1 bis 10, dadurch gekennzeichnet, dass die beiden Teile (15, 16) der Abschirmeinheit (14) miteinander verclipst werden können.

12. Abschirmeinheit für eine Kabeldurchführungsvorrichtung nach einem der Ansprüche 1 bis 11, dadurch gekennzeichnet, dass die Abschirmeinheit (13, 14) aus zwei Teilen (15, 16) besteht, die um Teile eines Stopfens (1) der Kabeldurchführungsvorrichtung angeordnet und aneinander befestigt werden können.

13. Abschirmeinheit nach Anspruch 12, dadurch gekennzeichnet, dass die Abschirmeinheit (13, 14) aus einem Drahtgeflecht oder einer metallischen Folie oder aus einer metallisch beschichteten Folie oder aus mindestens einem metallisch beschichteten Teil (15, 16) aus Kunststoff besteht.

14. Abschirmeinheit nach einem der Ansprüche 12 oder 13, dadurch gekennzeichnet, dass die Abschirmeinheit (13, 14) eine im wesentlichen kegelstumpfförmige Gestalt aufweist.

15. Abschirmeinheit nach einem der Ansprüche 12 bis 14, dadurch gekennzeichnet, dass die Abschirmeinheit (13, 14) Nasen (19) aufweist, die in die mit der Erde verbundene Abschirmung eines Kabels (12) eingreifen können.

16. Abschirmeinheit nach einem der Ansprüche 12 bis 15, dadurch gekennzeichnet, dass die Abschirmeinheit (14) eine Oberflächenstrukturierung (20) aufweist, die einer Wandung, durch die das Kabel (12) hindurchgeführt werden soll, zugewandt ist.

17. Abschirmeinheit nach einem der Ansprüche 12 bis 16, dass die beiden Teile (15, 16) der Abschirmeinheit (13, 14) miteinander verclipst werden können.

## Claims

1. Cable feedthrough device with a plug (1) made of a resilient material and comprising a through bore (3) for receiving a cable (12) and a groove (6) for positioning the plug (1) in a bore of a wall, the cable feedthrough device comprising a screening unit (13, 14) meeting the EMC requirements, characterised in that the cable feedthrough device comprises further a strain relief unit (2) and that the screening unit (13, 14) consists of two parts (15, 16), which are arranged around parts of the plug (1) with the strain relief unit (2) fastened thereto and which can be connected to one another.

2. Cable feedthrough device as claimed in claim 1, characterised in that the strain relief unit (2) comprises a retaining clamp (9) by means of which the strain relief unit (2) can be clamped to the cable (12).

3. Cable feedthrough device as claimed in any one of claims 1 or 2, characterised in that the strain relief unit (2) comprises an approximately semicircular bracket (11), which can engage in the groove (6) of the plug (1).

4. Cable feedthrough device as claimed in any one of claims 2 or 3, characterised in that the strain relief unit (2) further comprises a web-shaped leg (10), which extends between the retaining clamp (9) and the bracket (11).

5. Cable feedthrough device as claimed in any one of claims 1 to 4, characterised in that the screening unit (13, 14) consists of a wire mesh or of a metal foil or of a foil coated with metal or of at least one part (15, 16) of plastics material coated with metal.

6. Cable feedthrough device as claimed in any one of claims 4 or 5, characterised in that the screening unit (13, 14) can be connected or is connected at that side of the web-shaped leg (10) opposite to the cable (12), preferably it can be glued or can be riveted or it is glued or riveted thereto.

7. Cable feedthrough device as claimed in any one of claims 1 to 6, chatacterised in that the screening unit (13, 14) substantially comprises the shape of a truncated cone.

8. Cable feedthrough device as claimed in any one of claims 1 to 7; characterised in that the screening unit (13, 14) comprises projections (19), which can engage in the screening of the cable (12) connected to earth.

9. Cable feedthrough device as claimed in any one of claims 1 to 8, characterised in that the plug (1) consists of soft rubber or plastics material, in particular of EPDM, silicone or neoprene.

10. Cable feedthrough device as claimed in any one of claims 1 to 9, characterised in that the semicircular bracket (11) forming part of the strain relief unit (2) and/or the screening unit (14) have a textured surface (20), which faces the wall through which the cable (12) is to be guided.

11. Cable feedthrough device as claimed in any one of claims 1 to 10, characterised in that the two parts (15, 16) of the screening unit (14) can be clipped on one another.

12. Cable feedthrough device as claimed in any one of claims 1 to 11, characterised in that the screening unit (13, 14) consists of two parts (15, 16), which can be arranged around parts of a plug (1) of the cable feedthrough device and connected to each other.

13. Cable feedthrough device as claimed in claim 12, characterised in that the screening unit (13, 14) consists of a wire mesh or of a metal foil or of a foil coated with metal or of at least one part (15, 16) of plastics material coated with metal.

14. Cable feedthrough device as claimed in any one of claims 12 or 13, characterised in that the screening unit (13, 14) substantially comprises the shape of a truncated cone.

15. Cable feedthrough device as claimed in any one of claims 12 to 14, characterised in that the screening unit (13, 14) comprises projections (19), which can engage in the screening of a cable (12) connected to earth.

16. Cable feedthrough device as claimed in any one of claims 12 to 15, characterised in that the screening unit (14) comprises a textured surface (20), which faces a wall through which the cable (12) is to be guided.

17. Cable feedthrough device as claimed in any one of claims 12 to 16, characterised in that the two parts (15, 16) of the screening unit (13, 14) can be clipped on one another.

## Revendications

1. Dispositif de traversée pour câble comportant un bouchon (1) réalisé en un matériau élastique, qui comprend un perçage traversant (3) servant à loger un câble (12) et une gorge (6) permettant l'insertion du bouchon (1) dans un perçage formé dans une paroi, le dispositif de traversée pour câble comprenant une unité de blindage (13,14) conforme aux normes réglementaires relatives aux ondes électromagnétiques, caractérisé en ce que le dispositif de traversée pour câble comporte en outre une unité de détente de traction (2) et que l'unité de blindage (13,14) est constituée de deux parties (15,16), qui peuvent être disposées autour de parties du bouchon (1), auquel est fixée l'unité de détente de traction (2), et peuvent être fixées l'une à l'autre.

2. Dispositif de traversée pour câble selon la revendication 1, caractérisé en ce que l'unité de détente de traction (2) comprend une pince de retenue, au moyen de laquelle l'unité de détente de traction (2) peut être fixée par serrage sur le câble (12).

3. Dispositif de traversée pour câble selon l'une des revendications 1 ou 2, caractérisé en ce que l'unité de détente de traction (2) comporte un étrier (11) de forme approximativement semi-circulaire, qui peut s'engager dans la gorge (6) du bouchon (1).

4. Dispositif de traversée pour câble selon l'une des revendications 2 ou 3, caractérisé en ce que l'unité de détente de traction (2) comporte en outre une branche en forme de barrette (10), qui s'étend entre la pince de retenue (9) et l'étrier (11).

5. Dispositif de traversée pour câble selon l'une des revendications 1 à 4, caractérisé en ce que l'unité de blindage (13,14) est constituée par un treillis de fils ou par une feuille métallique ou par une feuille recouverte d'un revêtement métallique ou par au moins une partie (15, 16) en matière plastique, pourvue d'un revêtement métallique.

6. Dispositif de traversée pour câble selon l'une des revendications 4 ou 5, caractérisé en ce que l'unité de blindage (13, 14) peut être fixée ou est fixée, de préférence peut être collée ou rivetée ou est collée ou rivetée sur le côté, qui est éloigné du câble (12), de la branche en forme de barrette (10).

7. Dispositif de traversée pour câble selon l'une des revendications 1 à 6, caractérisé en ce que l'unité de blindage (13,14) possède une configuration de forme essentiellement tronconique.

8. Dispositif de traversée pour câble selon l'une des revendications 1 à 7, caractérisé en ce que l'unité de blindage (13,14) comporte des becs (19), qui peuvent s'engager dans le blindage relié à la terre, du câble (12).

9. Dispositif de traversée pour câble selon l'une des revendications 1 à 8, caractérisé en ce que le bouchon (1) est réalisé en caoutchouc mou ou en une matière plastique, notamment du EPDM, du silicone ou du néoprène.

10. Dispositif de traversée pour câble selon l'une des revendications 1 à 9, caractérisé en ce que l'étrier de forme semi-circulaire (11), qui est compris dans l'unité de détente de traction (2), et/ou l'unité de blindage (14) possède une structuration de surface (20), qui est tournée vers la paroi que le câble (12) doit traverser.

11. Dispositif de traversée pour câble selon l'une des revendications 1 à 10, caractérisé en ce que les deux parties (15,16) de l'unité de blindage (14) peuvent être fixées entre elles par encliquetage.

12. Unité de blindage pour un dispositif de traversée pour câble selon l'une des revendications 1 à 11,
caractérisée en ce que l'unité de blindage (13,14) est formée de deux parties (15,16), qui peuvent être disposées autour de parties d'un bouchon (1) du dispositif de traversée pour câble et être fixées l'une à l'autre.

13. Unité de blindage selon la revendication 12, caractérisée en ce que l'unité de blindage (13,14) est constituée par un treillis de fils ou par une feuille métallique ou par une feuille recouverte d'un revêtement métallique ou par au moins une partie (15,16) en matière plastique, pourvue d'un revêtement métallique.

14. Unité de blindage selon l'une des revendications 12 ou 13, caractérisée en ce que l'unité de blindage (13,14) possède une configuration de forme essentiellement tronconique.

15. Unité de blindage selon l'une revendications 12 à 14, caractérisée en ce que l'unité de blindage (13,14) comporte des becs (19), qui peuvent s'engager dans le blindage relié à la terre, du câble (12).

16. Unité de blindage selon l'une des revendications 12 à 15, caractérisée en ce que l'unité de blindage (14) possède une structuration de surface (20), qui est tournée vers une paroi, que le câble (12) doit traverser.

17. Unité de blindage selon l'une des revendications 12 à 16, caractérisée en ce que les deux parties (15,16) de l'unité de blindage (13,14) peuvent être encliquetées l'une sur l'autre.
